# EUROPEAN PATENT SPECIFICATION

(11) **EP 2 648 235 B1**
(45) Date of publication and mention of the grant of the patent: **02.11.2016**
(21) Application number: 12191136.6
(22) Date of filing: 02.11.2012
(51) Int. Cl.: H01L 31/18

(54) **Method of manufacturing photoelectric device by ion implantation**
Verfahren zum Herstellen einer photoelektrischen Vorrichtung mittels Ionenimplantierung
Procédé de fabrication d'un dispositif photoélectrique à implantation ionique

(30) Priority: 04.04.2012 US 201261620376 P; 12.09.2012 US 201213612687
(43) Date of publication of application: 09.10.2013
(73) Proprietor: Samsung SDI Co., Ltd., Yongin-si, Gyeonggi-do (KR)
(72) Inventor: Kim, Young-Jin, Chungcheongnam-do 331-300 (KR); Lee, Doo-Youl, Chungcheongnam-do 331-300 (KR); Kim, Young-Su, Chungcheongnam-do 331-300 (KR); Mo, Chan-Bin, Chungcheongnam-do 331-300 (KR); Park, Young-Sang, Chungcheongnam-do 331-300 (KR); Shin, Jae-Ho, Chungcheongnam-do 331-300 (KR); Park, Sang-Jin, Chungcheongnam-do 331-300 (KR); Seo, Sang-Won, Chungcheongnam-do 331-300 (KR); Song, Min-Chul, Chungcheongnam-do 331-300 (KR); Kim, Dong-Seop, Chungcheongnam-do 331-300 (KR)
(74) Representative: Mounteney, Simon James

(56) References cited:
- WO-A1-2013/166171
- US-A1- 2009 227 094
- US-A1- 2010 304 522
- US-A1- 2011 139 230

## Description

### [Technical Field]

The present invention relates to a method of manufacturing a photoelectric device.

### [Related Art]

Currently, due to problems such as exhaustion of energy resources and environmental pollution of the earth, development of clean energy sources is accelerated. As a clean energy, photovoltaic energy generated using solar cells is directly transformed from sunlight and thus is regarded as a new energy source.

However, costs for generating photovoltaic energy that is currently industrially generated by using solar cells are high in comparison to generation of thermal energy, and power generation efficiency of the solar cells has to be increased to allow broad application fields of the solar cells. In order to mass produce high efficiency solar cells, manufacturing cost and process simplification are necessarily developed.

US2010/0304522 discloses an ion implantation fabrication process for thin-film crystalline silicon solar cells, including rear emitter regions, selective emitter regions, and back surface, field regions.

US2011/0139230 discloses ion implanted selective emitter solar cells with in situ surface passivation, using n-type doped first and second regions on a p-type doped silicon substrate, where the second region is more heavily doped than the first region.

US2009/0227094 discloses a fabrication method for an interdigitated back contact (IBC) solar cell, wherein back-surface field regions and emitter regions are formed on the back surface of a substrate via two successive masked ion implantation steps.

### [Disclosure of the Invention]

### [Technical Goal of the Invention]

There is disclosed a photoelectric device having a reduction in the number of processes for manufacturing the photoelectric device and improved output characteristics.

### [Means for Achieving Technical Goal]

According to one or more embodiments, the present invention includes a method of manufacturing a photoelectric device as defined in the independent claim 1, the method including: forming a first semiconductor layer on a semiconductor substrate through a first ion implantation; forming a second semiconductor layer having a conductive type inverse to that of the first semiconductor layer on a part of the first semiconductor layer through a second ion implantation; and performing thermal processing to repair lattice damage in the semiconductor substrate and activate the dopants implanted by the first and second ion implantations.

A dopant having a conductive type inverse to that of the semiconductor substrate is implanted during the first ion implantation, and a dopant having the same conductive type as that of the semiconductor substrate is implanted during the second ion implantation.

The dopant is selectively implanted in a partial region corresponding to an opening pattern of a mask during the second ion implantation.

Regarding projection ranges in which the dopants are projected into a surface of the semiconductor substrate during the first and second ion implantations, the projection range of the second ion implantation is deeper than that of the first ion implantation.

An ion dose of the second ion implantation is higher than that of the first ion implantation.

The thermal processing is performed at a temperature of about 950°C ∼ about 1100°C. The thermal processing may optionally be performed in a nitrogen or oxygen atmosphere.

The depth of the second semiconductor layer is deeper than that of the first semiconductor layer (e.g. after the thermal processing is performed).

The surface concentration of the second semiconductor layer is higher than that of the first semiconductor layer (e.g. after the thermal processing is performed).

The method may optionally further include, between the first and second ion implantations and the performing of the thermal processing, forming an anti-diffusion layer on the first and second semiconductor layers (e.g. between the first and second ion implantations and the performing of the thermal processing).

The anti-diffusion layer can include undoped silicate glass (USG).

The first and second ion implantations are performed on a first surface of the semiconductor substrate, wherein the method further includes: forming a front surface field (FSF) on a second surface of the semiconductor substrate through the third ion implantation.

The method may optionally further include: after the third ion implantation, passivating the first and second surfaces of the semiconductor substrate.

The passivating includes: an oxidation process for forming a silicon oxide layer in the first and second surfaces of the semiconductor substrate.

The present invention further includes a method of manufacturing a photoelectric device as defined in the independent claim 1, the method including: forming a first semiconductor layer on a first surface of a semiconductor substrate through a first ion implantation; forming a second semiconductor layer having a conductive type inverse to that of the first semiconductor layer on a part of the first semiconductor layer through a second ion implantation; forming a FSF on a second surface of the semiconductor substrate opposite to the first surface through a third ion implantation; and performing a united thermal processing step, which includes thermal processing, to activate dopants implanted by the first to third ion implantations, and passivating on the first and second surfaces of the semiconductor substrate.

The performing of the united thermal processing step can include: forming a silicon oxide layer in the first and second surfaces of the semiconductor substrate.

The performing of the united thermal processing includes: applying first and second processing conditions to the semiconductor substrate in a reactor, wherein the first processing conditions includes a temperature of about 950°C ∼ about 1100°C, and a pressure below 0.5 torr in a nitrogen atmosphere for 10 minutes ∼ 100 minutes, and second processing conditions, includes oxygen radicals being formed by supplying hydrogen and oxygen together at a temperature of about 950°C ∼ about 1100°C as in the first processing conditions or at a temperature of about 800°C ∼ about 950°C and a pressure of below 0.5 torr.

The first processing conditions includes a temperature of about 950°C ∼ about 1100°C, and a pressure above 700 torr in a nitrogen atmosphere for 10 minutes ∼ 100 minutes, the second processing conditions includes a temperature of about 950°C ∼ about 1100°C or at a temperature of about 800°C ∼ about 950°C in an oxygen atmosphere and a pressure above 700 torr.

The first processing conditions includes forming oxygen radicals by supplying hydrogen and oxygen together at a temperature of about 800°C ∼ about 950°C, and a pressure below 0.5 torr, and the second processing conditions includes a temperature of about 950°C ∼ about 1100°C and a pressure below 0.5 torr in a nitrogen atmosphere for 10 minutes - 100 minutes.

The first processing conditions includes an oxygen atmosphere a temperature of about 800°C ∼ about 950°C, and a pressure above 700 torr, and the second processing conditions includes a high temperature of about 950°C ∼ about 1100°C and a pressure above 700 torr in a nitrogen atmosphere for 10 minutes - 100 minutes.

A reaction gas containing hydrogen chloride or hydrogen may optionally be implanted in addition to the oxygen atmosphere during the second processing.

The method may optionally further include, between the first and second ion implantations and the performing of the united thermal processing, forming an anti-diffusion layer on the first surface of the semiconductor substrate.

The anti-diffusion layer preferably includes USG.

### [Effect of the Invention]

As described above, according to the one or more of the above embodiments of the present invention, a first semiconductor layer is formed by applying a first ion implantation throughout a front surface of a semiconductor substrate, and a counter-doped second semiconductor layer is formed by overlappingly applying the first ion implantation and a second ion implantation to a partial selected region. Accordingly, the number of processes for manufacturing a photoelectric device is reduced, which reduces a rate of occurrence of a process defect, thereby improving product yield and reducing manufacturing cost.

Furthermore, the first and second semiconductor layers are formed by implanting ions and therefore the ion dose implanted into the semiconductor substrate can be easily controlled. Additionally, by varying the amount of energy accelerating the ion beam during the ion implantation, the doping profile and junction depth are also elaborately controlled. Precisely controlling these variables can help in reducing junction leakage current, enhancing an open circuit voltage, and ultimately enhancing photoelectric conversion efficiency.

### [Brief Description of the Drawings]

FIGS. 1A through 1M are schematic sequential cross-sectional views for describing a method of manufacturing a photoelectric device, according to an embodiment of the present invention;
FIGS. 2A and 2B are diagrams of opening patterns of masks applicable to the second ion implantation;
FIG. 3 is a schematic perspective view of second ion implantation, in which a second semiconductor layer of various shapes is formed on a semiconductor substrate according to an opening pattern of a mask;
FIGS. 4A through 4L are sequential cross-sectional views for describing a method of manufacturing a photoelectric device according to a comparison example not being part of the present invention; and
FIGS. 5A through 5L are sequential cross-sectional views for describing a method of manufacturing a photoelectric device, according to another embodiment of the present invention.

### [Description of Embodiment]

Reference will now be made in detail to embodiments, examples of which are illustrated in the accompanying drawings, wherein like reference numerals refer to the like elements throughout.

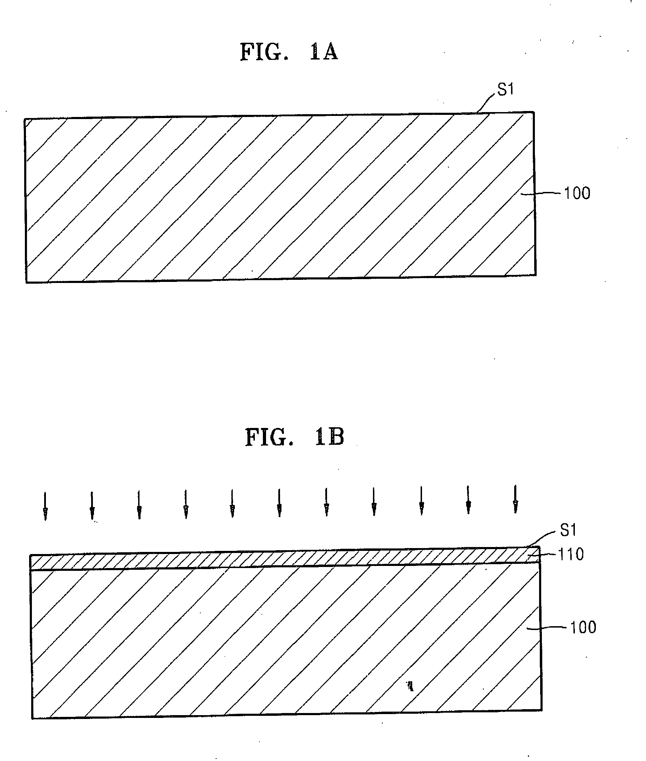

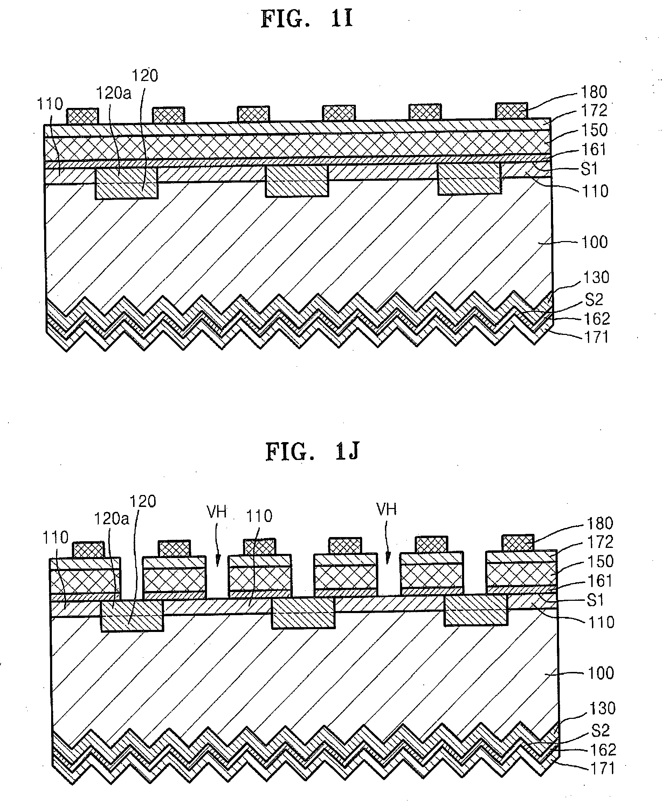

FIGS. 1A through 1M are schematic sequential cross-sectional views for describing a method of manufacturing a photoelectric device, according to an embodiment of the present invention.

Referring to FIG. 1A, a semiconductor substrate 100 is prepared. The semiconductor substrate 100 is prepared as an n type or p type crystalline silicon wafer. For example, to remove a sawing damage that occurs when the semiconductor substrate 100 is manufactured or physical and chemical impurities attached to the semiconductor substrate 100, a cleaning process of applying an alkaline solution such as KOH or NaOH is applied.

Referring to FIG. 1B, a first semiconductor layer 110 is formed on the semiconductor substrate 100 by using first ion implantation. The first ion implantation is performed over the overall of a first surface S1 of the semiconductor substrate 100. The first semiconductor layer 110 is formed in an overall region of the semiconductor substrate 100.

The first semiconductor layer 110 may be doped in a conductive type inverse to that of the semiconductor substrate 100 to form a p-n junction. According to an embodiment of the present invention, the first semiconductor layer 110 is formed as a doping layer having an inverted conductive type by implanting a p type dopant into the n type semiconductor substrate 100 or is formed as a doping layer having an inverted conductive type by implanting an n type dopant into the p type semiconductor substrate 100. The first semiconductor layer 110 forms an emitter that collects minority carriers generated from the semiconductor substrate 100.

For example, during the first ion implantation, a projection range that is a straight distance of a dopant projected from the surface of the semiconductor substrate 100 may be set as about 5 nm ∼ about 300 nm, and the implanted ion dose may be set as about 10¹⁴atoms/cm² ∼ about 10¹⁶atoms/cm².

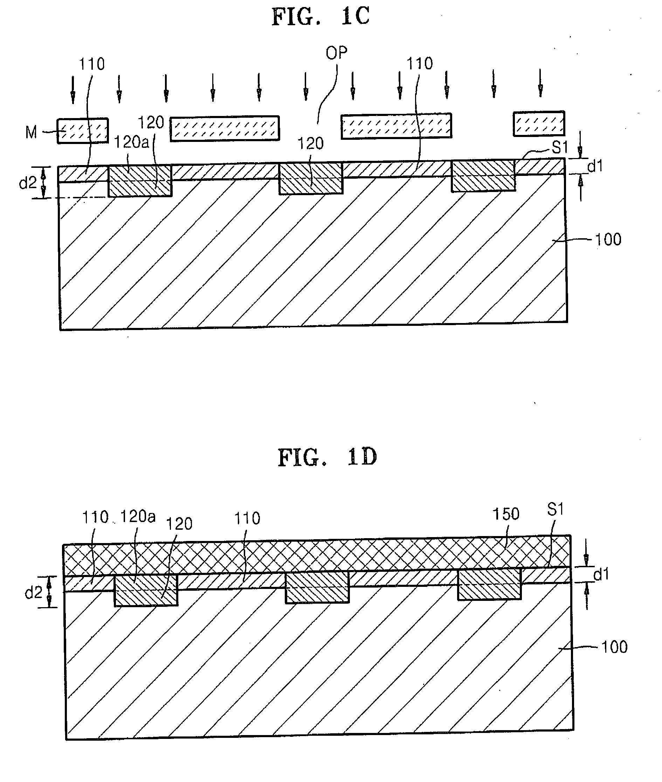

Referring to FIG. 1C, second semiconductor layers 120 are formed in the semiconductor substrate 100 by using second ion implantation. The second ion implantation is performed by selectively implanting ions into a corresponding region of an opening pattern OP using a mask M in which the opening pattern OP is formed, and thus the second semiconductor layers 120 are formed in a part of the semiconductor substrate 100. Counter doping that implants a dopant having a conductive type inverse to that of the first semiconductor layer 110 is performed during the second ion implantation, and thus the second semiconductor layers 120 having conductive types inverse to that of the first semiconductor layer 110 is formed.

For example, the second semiconductor layer 120 is doped in the same conductive type as that of the semiconductor substrate 100, and is doped at a higher concentration than that of the semiconductor substrate 100, and thus a high-low junction is formed. The second semiconductor layers 120 are formed by implanting the n type dopant into the n type semiconductor substrate 100 or by implanting the p type dopant into the p type semiconductor substrate 100. The second semiconductor layers 120 form bases that collect a plurality of carriers generated from the semiconductor substrate 100. The second semiconductor layers 120 can form a back surface field (BSF) to reduce a surface recombination loss in the first surface S1 of the semiconductor substrate 100, that is, in a rear surface thereof.

For example, during the second ion implantation, the projection range that is the straight distance of the dopant projected from the surface of the semiconductor substrate 100 may be set as about 5 nm ∼ about 300 nm, and the implanted ion dose may be set as about 10¹⁴atoms/cm² ∼ about 10¹⁶atoms/cm².

For example, the projection range of the second ion implantation is set greater than that of the first ion implantation. The projection range of the second ion implantation is increased in relation to the first ion implantation in such a way that a h-I junction depth d2 by the second ion implantation is deeper than a p-n junction depth d1 by the first ion implantation. The projection range varies with respect to an amount of energy that accelerates ion beam.

For example, the ion dose of the second ion implantation can be set higher than that of the first ion implantation preceding the second ion implantation. To form the second semiconductor layers 120 having the inverted conductive type in a partial region of the semiconductor substrate 100 by performing the first and second ion implantations so that they overlap, the ion dose of the second ion implantation is relatively higher than the ion dose of the first ion implantation.

The counter doping by the second ion implantation will now be described in more detail with reference to FIGS. 1 B and 1C. Referring to FIG. 1B, the first semiconductor layer 110 is formed over the overall first surface S1 of the semiconductor substrate 100 by performing the first ion implantation, and thereafter the second ion implantation is performed. During the second ion implantation, the mask M in which the opening pattern OP is formed is disposed on the first semiconductor layer 110, and a dopant is selectively implanted into a corresponding region of the opening pattern OP. In this regard, the dopant having a conductive type inverse to that of the first semiconductor layer 110 is implanted, and thus the second semiconductor layers 120 having inverted conductive types is formed (counter doping).

For example, the p-n junction is formed in a contact region between the first semiconductor layer 110 and bulk regions of the semiconductor substrate 100, and the h-I junction (high concentration-low concentration junction) is formed in a contact region between the second semiconductor layers 120 and bulk regions of the semiconductor substrate 100. In this regard, the h-I junction is formed at a location deeper than the p-n junction, that is, a location relatively far away from the first surface S1 of the semiconductor substrate 100, and the junction depth d2 of the h-I junction and the junction depth d1 of the p-n junction have a relationship of d2 > d1. If the junction depth d2 of the h-I junction is shallower than the junction depth d1 of the p-n junction, i.e. d2 < d1, since the second semiconductor layers 120 formed in the selective region of the semiconductor substrate 100 is surrounded by the first semiconductor layer 110 formed over the overall region of the semiconductor substrate 100, the carriers generated in the semiconductor substrate 100 do not move to the second semiconductor layers 120 due to an electric potential barrier of the first semiconductor layer 110, which deteriorates collection efficiency of carriers.

Although the junction depth d1 of the p-n junction is approximately equal to a thickness of the first semiconductor layer 110, and the junction depth d2 of the h-I junction is approximately equal to thicknesses of the second semiconductor layers 120 in FIG. 1C, this is merely for easy understanding of a relative location relationship between the junction depth d1 of the p-n junction and the junction depth d2 of the h-I junction and does not show an actual location of the p-n junction or the h-I junction. Although the p-n junction or the h-I junction can be formed around a boundary contacting the first and second semiconductor layers 110 and 120 and bulk regions of the semiconductor substrate 100, the p-n junction or the h-I junction can be formed inside the first and second semiconductor layers 110 and 120.

The junction depth d1 of the p-n junction and the junction depth d2 of the h-I junction varies with respect to the amount of energy that accelerates the ion beam during the first and second ion implantations. For example, if ion beam having a relatively high energy collides the semiconductor substrate 100, the junction depth d1 and the junction depth d2 increase, whereas ion beam having a relatively low energy collides the semiconductor substrate 100, the junction depth d1 and the junction depth d2 decrease.

The junction depth d1 of the p-n junction or the junction depth d2 of the h-I junction described above does not indicate a status after the first and second ion implantations but indicates a status after thermal processing is performed to repair lattice damage due to the first and second ion implantations and activate implanted dopants. That is, the junction depth d1 of the p-n junction or the junction depth d2 of the h-l junction means the junction depth d1 or the junction depth d2 in a final product status after a general process is completely finished.

Meanwhile, the surfaces of the second semiconductor layers 120 include counter doping portions 120a that are doped in the same conductive type as that of the first semiconductor layer 110 after the first ion implantation and is inverted in its conductive type by implanting a counter conductive type dopant during the second ion implantation.

The surfaces of the second semiconductor layers 120, for example, the counter doping portions 120a, are be doped at a higher concentration than that of the first semiconductor layer 110. That is, to offset the p type or n type dopant implanted with the first semiconductor layer 110 during the first ion implantation, and furthermore form the second semiconductor layers 120 having the inverted n type or p type conductive type, a greater amount of dopants of the second semiconductor layers 120 than that of dopants of the first semiconductor layer 110 are implanted. For example, a doping concentration of the surfaces of the second semiconductor layers 120 is set to be higher than that of the surface of the first semiconductor layer 110. In this regard, the doping concentration does not indicate a status after the first and second ion implantations but indicates a status after thermal processing is performed to repair lattice damage due to the first and second ion implantations and activate implanted dopants. That is, the doping concentration means a doping concentration in a final product status after a general process is completely finished.

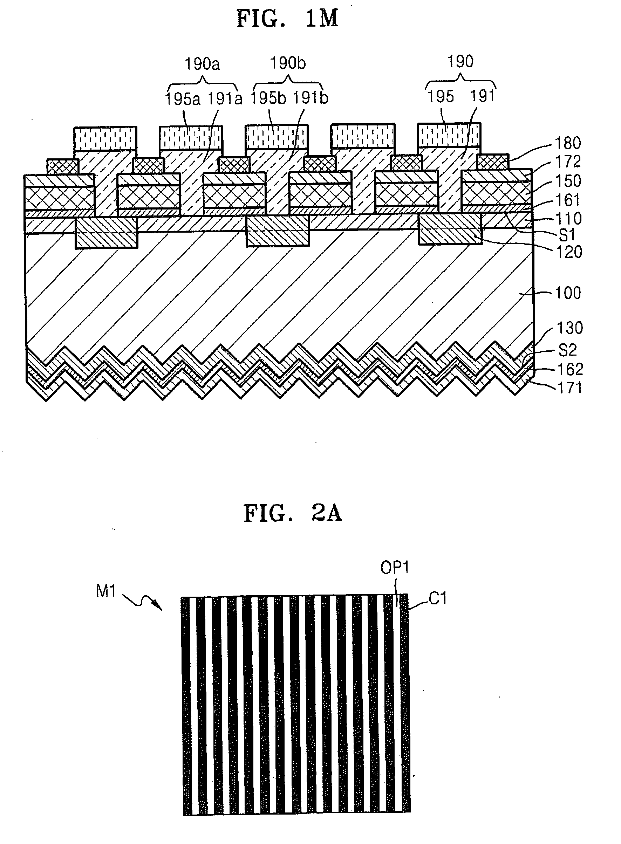

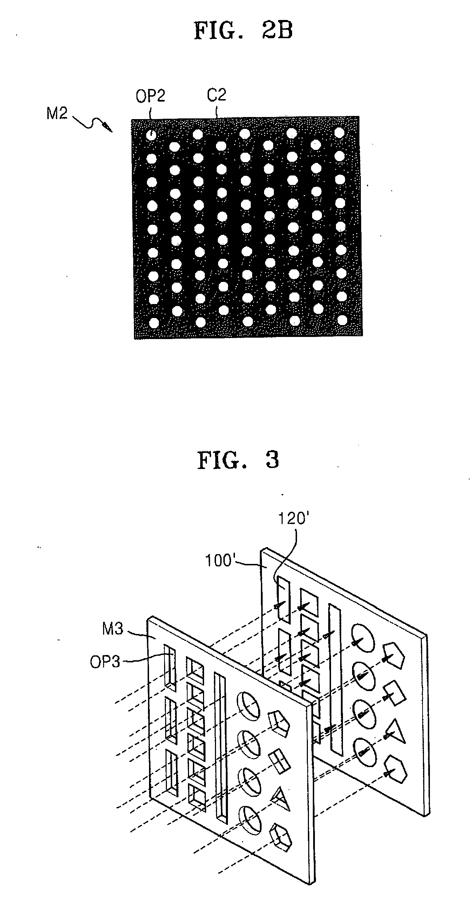

FIGS. 2A and 2B are diagrams of opening patterns OP1, OP2 of masks M1, M2 applicable to a second ion implantation. During the second ion implantation, the second semiconductor layers 120 are formed by selectively implanting an n type or p type dopant into regions corresponding to the opening patterns OP1, OP2 of the masks M1, M2.

If the mask M1 of FIG. 2A is applied, the first and second semiconductor layers 110 and 120 may be alternately formed in stripe patterns. For example; the opening pattern OP1 of the mask M1 forms the second semiconductor layer 120 that is counter-doped from the first semiconductor layer 110 and is inverted in its conductive type, and a closed part C1 of the mask M1 forms the first semiconductor layer 110 that remains unchanged.

If the mask M2 of FIG. 2B is applied, the second semiconductor layers 120 can be formed in an isolation shape of a dot or island type, and the first semiconductor layer 110 can be formed to surround the second semiconductor layers 120 in the isolation shape. For example, the opening pattern OP2, for example, the circular opening pattern OP2, of the mask M2 forms the second semiconductor layers 120 that is counter-doped from the first semiconductor layer 110 and is inverted in its conductive type, and a closed part C2 of the mask M2 forms the first semiconductor layer 110 that remains unchanged.

The circular second semiconductor layers 120 can be formed by applying the mask M2 of FIG. 2B. As described above, areas of the first and second semiconductor layers 110 and 120 are differently designed, thereby enhancing collection efficiency of carriers. That is, the first semiconductor layer 110 that collects minority carriers is relatively widely formed, thereby enhancing collection efficiency of carriers.

The mask M2 of FIG. 2B is an example of forming the second semiconductor layers 120 in the isolation shape. For example, the opening pattern OP2 of the mask M2 can be formed in an oval or polygonal shape other than a circular shape.

For example, the masks M1, M2 are formed of a carbon based graphite material. In this regard, the graphite material includes a material for improving physical and chemical stability. Further, the masks M1, M2 may include a silicon carbide SiC or ceramic material. Such a selection of the material of the masks M1, M2 is to consider processability and material expense, and secure strength above an optimum level.

FIG. 3 is a schematic perspective view of second ion implantation, in which second semiconductor layers 120' of various shapes is formed on a semiconductor substrate 100' according to opening patterns OP3 of a mask M3.

Referring to FIG. 1 D, an anti-diffusion layer 150 is formed on the first surface S1 of the semiconductor substrate 100 after first and second ion implantations are performed. The anti-diffusion layer 150 prevents a dopant implanted into the semiconductor substrate 100 from diffusing to the outside during a thermal processing operation that will be described later. To prevent the dopant having an increased diffusion speed in a high temperature environment for thermal processing from diffusing to the outside of the semiconductor substrate 100, the anti-diffusion layer 150 is formed on the first surface S1 of the semiconductor substrate 100 in which the first and second semiconductor layers 110 and 120 are formed.

Further, as will be described later, the anti-diffusion layer 150 can serve as an anti-etching layer when a second surface of the semiconductor substrate 100 is textured, and can also function to protect the first and second semiconductor layers 110 and 120 from a texturing etchant.

Silicate glass can be applied as the anti-diffusion layer 150. More specifically, undoped silicate glass (USG) that does not include a p type or n type dopant can applied as the anti-diffusion layer 150. For example, the anti-diffusion layer 150 can be formed by using chemical vapor deposition (CVD) using tetraethyl orthosilicate (TEOS) or silane (SiH4), and having a thickness of about 50 ∼ about 300 nm.

Thereafter, thermal processing is performed to repair lattice damage of the semiconductor substrate 100 due to ion shocks of the first and second ion implantations and activate implanted dopants. For example, the implanted dopants are mostly located in interstitial site other than lattice sites and thus are not activated, and thus thermal processing is performed to activate the implanted dopants.

Thermal processing is performed at a high temperature lower than a fusion temperature and enough to repair the lattice damage and activate the implanted dopants, for example, at a high temperature lower than between about 950°C ∼ about 1100°C in a nitrogen or oxygen atmosphere.

After thermal processing is performed, a surface concentration of the first semiconductor layer 110 has a range of about 10¹⁸atoms/cc ∼ about 10²⁰atoms/cc, and the junction depth d1 of a p-n junction by the first semiconductor layer 110 has a range of about 0.5µm ∼ about 1.5µm. A surface concentration of the second semiconductor layer 120 has a range of about 5x10¹⁸atoms/cc ∼ about 10²¹atoms/cc, and the junction depth d2 of a h-I junction by the second semiconductor layer 120 has a range of about 0.7µm ∼ about 2.0µm. The surface concentrations of the first and second semiconductor layers110 and 120 and the junction depths d1, d2 are designed within the ranges stated above in order to form an ohmic contact with a metal electrode and reduce recombination loss of carriers.

The surface of the second semiconductor layer 120 is doped at a higher concentration than that of the first semiconductor layer 110. To overlappingly apply the first and second ion implantations to the surface of the second semiconductor layer 120 and invert a conductive type thereof, the surface concentration of the second semiconductor layer 120 is relatively higher than that of the first semiconductor layer 110, and a p type or n type dopant implanted during the second ion implantation offsets a p type or n type dopant implanted during the first ion implantation and invert the conductive type of the second semiconductor layer 120.

The h-I junction by the second semiconductor layer 120 is formed at a location deeper than the p-n junction by the first semiconductor layer 110, that is, at a location relatively far away from the first surface S1 of the semiconductor substrate 100. That is, the junction depth d2 of the h-I junction by the second semiconductor layer 120 and the junction depth d1 of the p-n junction by the first semiconductor layer 110 has a relationship of d2 > d1, and thus the second semiconductor layer 120 and bulk regions of the semiconductor substrate 110 form an electrical contact, and a plurality of carriers generated in the semiconductor substrate 100 is not blocked by an electric potential barrier of the first semiconductor layer 110 but is collected in the second semiconductor layer 120.

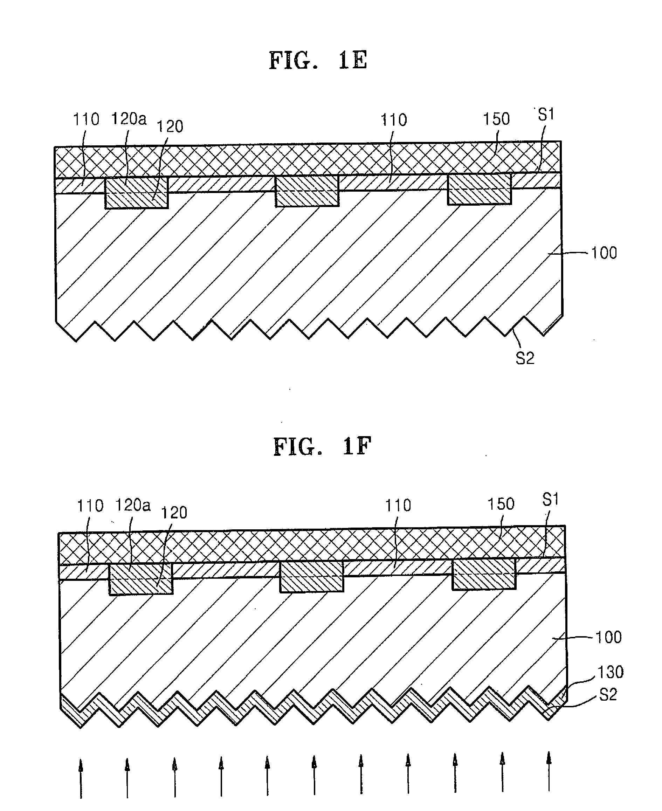

Referring to FIG. 1E, texturing is performed on a second surface S2 of the semiconductor substrate 100. For example, an etchant including isoprophyl alcohol (IPA) and adhesive added to an aqueous solution such as KOH, NaOH is applied to the semiconductor substrate 100 during texturing. In this regard, a texture structure of a pyramid pattern is formed in the second surface S2 of the semiconductor substrate 100 according to anisotropic etching characteristics with respect to a crystalline direction of single crystal silicon. The texture structure reduces reflectivity of incident light, and thus light collection efficiency increases, and an amount of the incident light as much as possible is absorbed into the semiconductor substrate 100. Meanwhile, the first surface S1 of the semiconductor substrate 100 covered by the anti-diffusion layer 150 is etched but is protected.

Referring to FIG. 1F, third ion implantation is used to form a front surface field (FSF) 130 on the second surface S2 of the semiconductor substrate 100. The third ion implantation is over the overall second surface S2 of the semiconductor substrate 100. The FSF 130 may be formed in an overall region of the second surface S2.

The FSF 130 is doped in the same conductive type as that of the semiconductor substrate 100 at a higher concentration than that of the semiconductor substrate 100 to form the h-I junction (high-low junction). The FSF 130 may be formed by implanting an n type dopant into the n type semiconductor substrate 100 or implanting a p type dopant into the p type semiconductor substrate 100. For example, the FSF 130 can prevent minority carriers from moving to the second surface S2 and recombining, and reduce surface recombination loss in the second surface S2, by forming a high concentration doping layer in the second surface S2 of the semiconductor substrate 100.

For example, during the third ion implantation, a projection range that is a straight distance of a dopant projected from the surface of the semiconductor substrate 100 may be set as about 5 nm ∼ about 500 nm, and the implanted ion dose may be set as about 10¹³atoms/cm² ∼ about 10¹⁵atoms/cm².

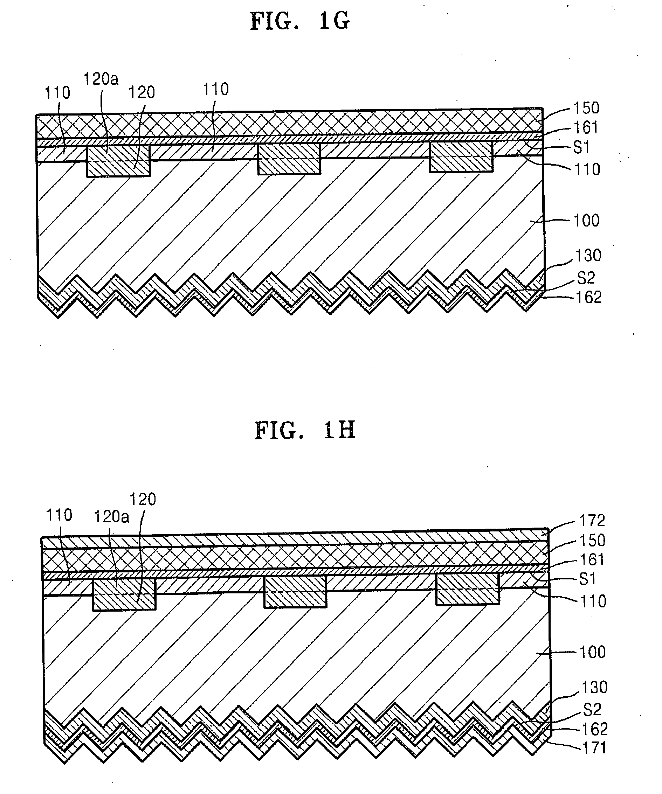

Referring to FIG. 1G, passivation layers 161 and 162 are formed in the first and second surfaces S1 and S2 of the semiconductor substrate 100. For example, a process of forming the passivation layers 161 and 162 includes an oxide process, and silicon oxide layers SiOx are formed as the passivation layers 161 and 162.

For example, the process of forming the passivation layers 161 and 162 are performed on the processing conditions i) and ii) below.
i) Oxygen radical is formed by supplying hydrogen and oxygen together at a high temperature of about 800°C∼ about 1100°C and at a low pressure below 0.5 torr as a pressure of a reactor.
ii) The process is performed in an oxygen atmosphere or a reaction gas containing hydrogen chloride or hydrogen is supplied in the oxygen atmosphere at a high temperature of about 800°C∼ about 1100°C and at a high pressure above 700 torr as a pressure of a reactor.

During the process of forming the passivation layers 161 and 162, oxygen contained in the reactor reacts silicon of the semiconductor substrate 100 through the anti-diffusion layer 150 formed on the first surface S1 of the semiconductor substrate 100, and accordingly, the passivation layer 161 grows in the first surface S1 of the semiconductor substrate 100. Oxygen contained in the reactor also reacts with silicon of the semiconductor substrate 100 on the second surface S2 of the semiconductor substrate 100, and accordingly, the passivation layer 162 grows in the second surface S2 of the semiconductor substrate 100.

The process of forming the passivation layers 161 and 162 is performed in a high temperature environment higher than 800°C, and thus thermal processing can be simultaneously performed to repair lattice damage due to ion shock during the third ion implantation and activate implanted dopants, and both effects of passivation and thermal processing are obtainable through one process.

After the process of forming the passivation layers 161 and 162 is performed, the surface concentration of the FSF 130 may have a range of about 10¹⁸atoms/cc ∼ about 5x10¹⁹atoms/cc, and a junction depth of the h-I junction (high-low junction) by the FSF 130 may have a range of about 0.3µm ∼ about 1.5µm.

Referring to FIG. 1H, an antireflective layer 171 is formed on the second surface S2 of the semiconductor surface 100. For example, the antireflective layer 171 is formed as a silicon nitride layer (SiNx). The antireflective layer 171 can be formed by using a CVD process. The antireflective layer 171 inhibits incident light from being reflected to promote absorption of light of the semiconductor substrate 100 and increase collection efficiency of light.

Meanwhile, the antireflective layer 171 is formed on the second surface S2 of the semiconductor substrate 100 and simultaneously an additional passivation layer 172 is formed on the first surface S1. The additional passivation layer 172 can reduce surface recombination loss of carriers in the first surface S1 of the semiconductor substrate 100 and enhance collection efficiency of carriers. The antireflective layer 171 of the second surface S2 an the additional passivation layer 172 of the first surface S1 is simultaneously formed through one process, and may substantially include the same material, for example, the silicon nitride layer (SiNx).

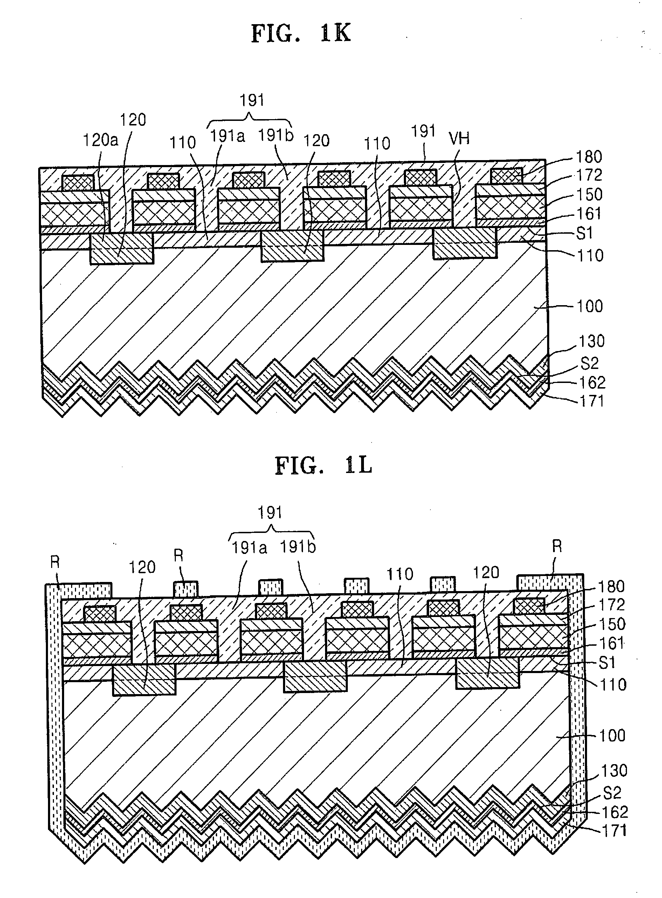

Referring to FIG. 1l, an insulation layer 180 is formed on the first surface S1 of the semiconductor substrate 100. As will be described later, first and second electrodes that form an electrical connection to the first and second semiconductor layers 110 and 120 are formed, and the insulation layer 180 functions to insulate the first and second electrodes having opposite conductive types.

For example, the insulation layer 180 is formed over boundaries of the first and second semiconductor layers 110 and 120, and is formed on the first surface S1 of the semiconductor substrate 100, that is, on the anti-diffusion layer 150 and the additional passivation layer 172. However, a location of the insulation layer 180 is not limited thereto.

For example, the insulation layer 180 is formed of a hardening resin material such as polyimide, is patterned by using screen printing or inkjet printing, and is obtained through thermal hardening. Alternatively, the insulation layer 180 is patterned by using screen printing or inkjet printing on an organosilicic compound comprising siloxane, and is obtained through thermal hardening.

Referring to FIG. 1J, via holes VH are formed on the first surface S1 of the semiconductor substrate 100 for an electrode connection. More specifically, the via holes VH are formed by removing parts of the additional passivation layer 172, the anti-diffusion layer 150, and the passivation layer 161 that cover the first and second semiconductor layers 110 and 120 for the electrode connection. For example, the via holes VH can be formed corresponding to the first and second semiconductor layers 110 and 120 that are alternately formed on the semiconductor substrate 100.

For example, an etching paste is applied to form the via holes VH, and is patterned in a predetermined region by using screen printing or inkjet printing.

Referring to FIG. 1 K, contact layers 191 are formed in the via holes VH as a part of an electrode. The contact layers 191 can include a multilayer structure in which aluminium (Al) - titanium tungsten alloy (TiW) - copper (Cu) are sequentially stacked. For example, aluminium (Al) of the contact layers 191 may be used to reduce contact resistance with the first and second semiconductor layers 110 and 120, the titanium tungsten alloy (TiW) thereof can be used to prevent copper (Cu) from diffusing, and copper (Cu) thereof can be used as a seed of a plating process that will be described later.

However, the contact layers 191 are generally used to reduce contact resistance with the first and second semiconductor layers 110 and 120, prevent copper (Cu) from diffusing, and as a seed of the plating process that will be performed later, and are formed to achieve at least one of objectives described above. For example, the contact layers 191 are formed by using sputtering, and are formed by continuously depositing aluminium (Al), titanium tungsten alloy (TiW), and copper (Cu) using high vacuum sputter equipment. Alternatively, the contact layers 191 are formed by coating an aluminum metal paste including silver (Ag) in the via holes VH by using screen printing, and thermal hardening or sintering on the aluminum metal paste. In a case where the contact layers 191 are formed by using a metal paste, forming gas annealing that will be described later may be omitted.

For example, the contact layers 191 can be formed to bury the via holes VH, and can be formed over the whole first surface S1 to cover the insulation layer 180 on the semiconductor substrate 100 after burying the via holes VH. In this regard, the contact layers 191 include first contact layers 191a on the first semiconductor layer 110 and second contact layers 191 b on the second semiconductor layer 120. Although the first contact layers 191a and the second contact layers 191b are connected to each other, the first contact layers 191a and the second contact layers 191b are separated from each other through a process that will be described later, and thus are insulated from each other.

Thereafter, the forming gas annealing is performed. Thermal processing is performed in a nitrogen atmosphere containing hydrogen of about 1% ∼ about 10% and at a high temperature of about 250°C ∼ about 400°C during the forming gas annealing. The forming gas annealing improves contact resistance between the first and second semiconductor layers 110 and 120 and the contact layers 191, and reduce a surface defect of the semiconductor substrate 100. For example, hydrogen atoms are coupled to a dangling bond and thus a defect density is reduced.

Referring to FIGS. 1L and 1M, a conductive connection layer 195 is formed on a selected part of the semiconductor substrate 100. More specifically, as shown in FIG. 1L, a resist R is coated. For example, the resist R is formed on the insulation layer 180, and can be additionally formed at the outermost including side surfaces of the semiconductor substrate 100. After forming the conductive connection layer 195, the resist R is removed, and thus the conductive connection layer 195 formed on the resist R is also removed. For example, the resist R can be formed by using screen printing or inkjet printing.

The conductive connection layer 195 is formed on the contact layer 191, which may form an electrode 190. For example, the conductive connection layer 195 mediates an electrical connection between the semiconductor substrate 100 and a wire substrate (not shown), and forms the electrical connection with the wire substrate through soldering. The conductive connection layer 195 can be formed by using wet electric plating having copper and tin as plating materials.

After the conductive connection layer 195 is formed, the resist R is removed, and thus the conductive connection layer 195 formed on the resist R is also removed. For example, the resist R can be removed by wet etching that applies chemicals. The contact layer 191 exposed from the conductive connection layer 195 is removed, and thus first and second electrodes 190a and 190b are separated from each other. For example, the contact layer 191 formed on the insulation layer 180 is removed, and thus the first and second electrodes 190a and 190b, more specifically, first and second contact layers 191 a and 191b, are separated from each other. Such a separation of electrodes can be performed by wet etching.

As shown in FIG. 1M, the first contact layer 191a and a first conductive connection layer 195a forms the first electrode 190a electrically connected to the first semiconductor layer 110, and the second contact layer 191b and a second conductive connection layer 195b forms the second electrode 190b electrically connected to the second semiconductor layer 120. The first and second electrodes 190a and 190b are separated from each other, and thus the first and second electrodes 190a and 190b having opposite conductive types are electrically insulated from each other.

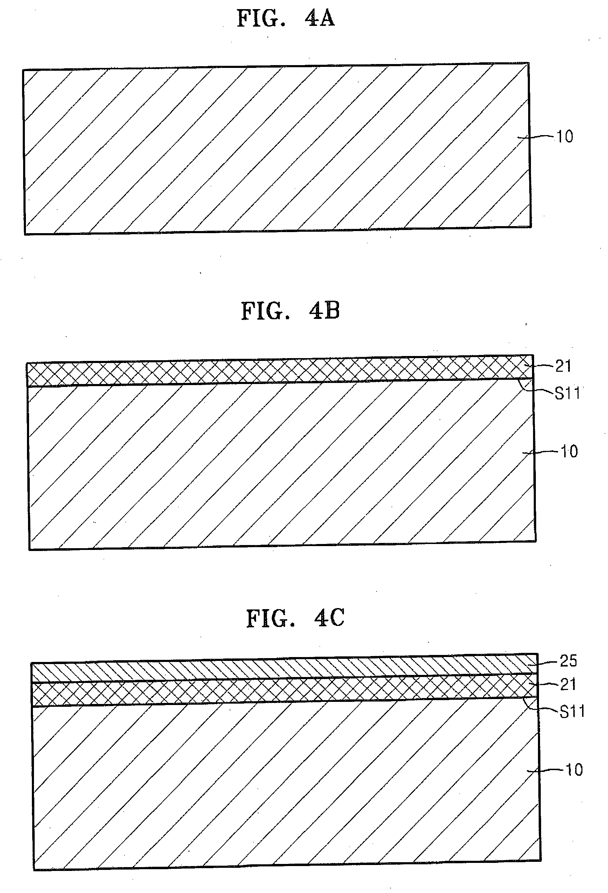

A method of manufacturing a photoelectric device according to a comparison example not being part of the present invention will be described with reference to FIGS. 4A through 4L.

Referring to FIG. 4A, a semiconductor substrate 10 is prepared.

Referring to FIGS. 4B and 4C, a first doping material layer 21 and an anti-reflective layer 25 are formed on a first surface S11 of the semiconductor substrate 10. The first doping material layer 21 is formed of phosphosilicate glass (PSG) or boron silicate glass (BSG) including p type or n type dopants inverse to that of the semiconductor substrate 10. The anti-reflective layer 25 is formed of USG that does not include p type or n type dopants.

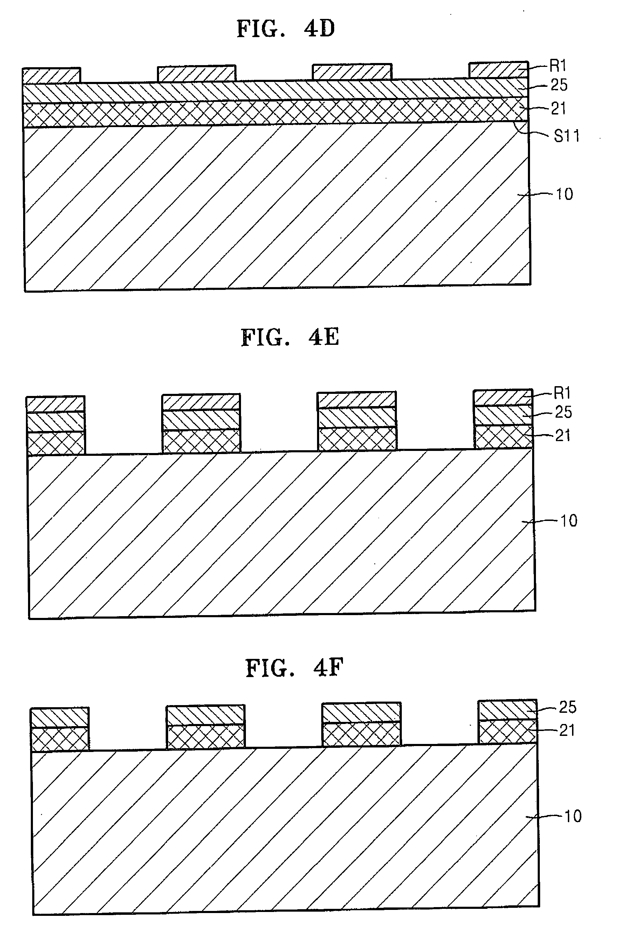

Referring to FIG. 4D, the resist R1 is patterned on the anti-reflective layer 25. The resist R1 is used to selectively form a first semiconductor layer in a part of the semiconductor substrate 10, and is patterned corresponding to the first semiconductor layer.

Referring to FIG. 4E, the first doping material layer 21 and the anti-reflective layer 25 exposed from the resist R1 are etched and removed by using the resist R1 as an etching protection layer. The first doping material layer 21 and the anti-reflective layer 25 are removed by applying hydro fluorine acid (HF) or a buffered oxide etchant (BOE). As shown in FIG. 4F, after etching, the resist R1 that is no longer useful is removed through separate chemical processing.

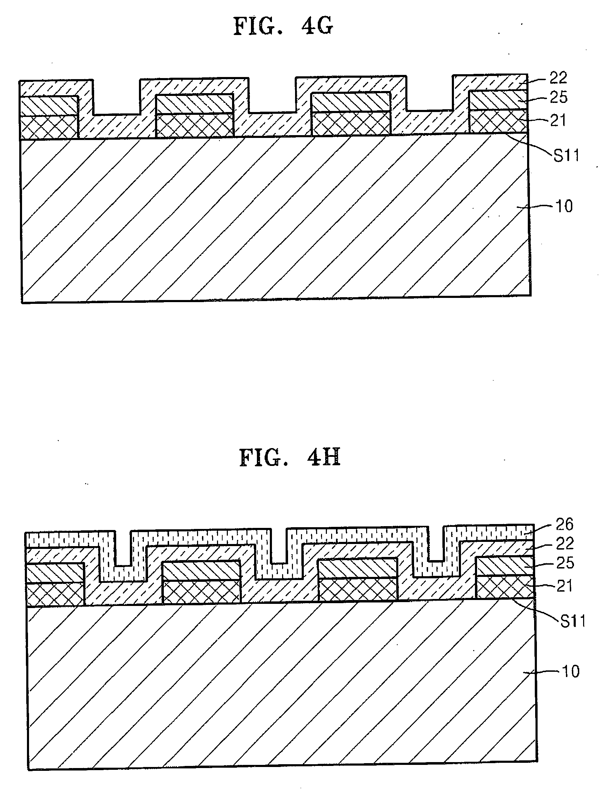

Referring to FIGS. 4G and 4H, a second doping material layer 22 and an anti-reflective layer 26 are formed on the first surface S11 of the semiconductor substrate 10. The second doping material layer 22 is formed of PSG or BSG including p type or n type dopants that is the same conductive type as that of the semiconductor substrate 10. The anti-reflective layer 26 is formed of USG that does not include p type or n type dopants.

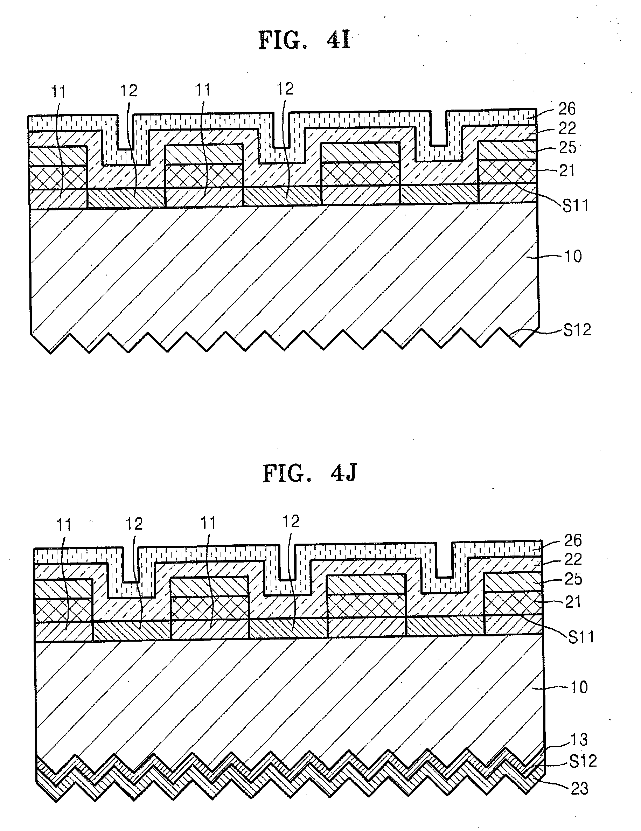

Referring to FIG. 4I, a drive-in that diffuses dopants of the first and second doping material layers 21 and 22 into the semiconductor substrate 10 is performed. If the p type and n type dopants of the first and second doping material layers 21 and 22 diffuse into the semiconductor substrate 10, the first and second semiconductor layers 11 and 12 are formed in the first surface S11 of the semiconductor substrate 10.

Referring to FIG. 4I, texturing is performed on the second surface S12 of the semiconductor substrate 10. A texture structure by which reflectivity of incident light is reduced is formed in first surface S11 of the semiconductor substrate 10. The first and second doping material layers 21 and 22 and the anti-diffusion layers 25 and 26 formed on the first surface S11 of the semiconductor substrate 10 function as anti-etching layers during texturing, and the first surface S11 of the semiconductor substrate 10 covered by the first and second doping material layers 21 and 22 and the anti-diffusion layers 25 and 26 are protected.

Referring to FIG. 4J, an FSF 13 is formed in the second surface S12 of the semiconductor substrate 10. For example, a doping source including the p type or n type dopants that is the same conductive type as that of the semiconductor substrate 10 is provided on the semiconductor substrate 10. For example, phosphorus oxychloride (POCl₃) is provided on the semiconductor substrate 10 in a diffusion tube as the doping source through a reaction gas that is a mixture of nitrogen and oxygen. In this regard, as dopants of the doping source diffuses into the semiconductor substrate 10, an oxide grows on the surface of the semiconductor substrate 10, and a third doping material layer 23 having a glass layer form such as PSG or BSG is formed.

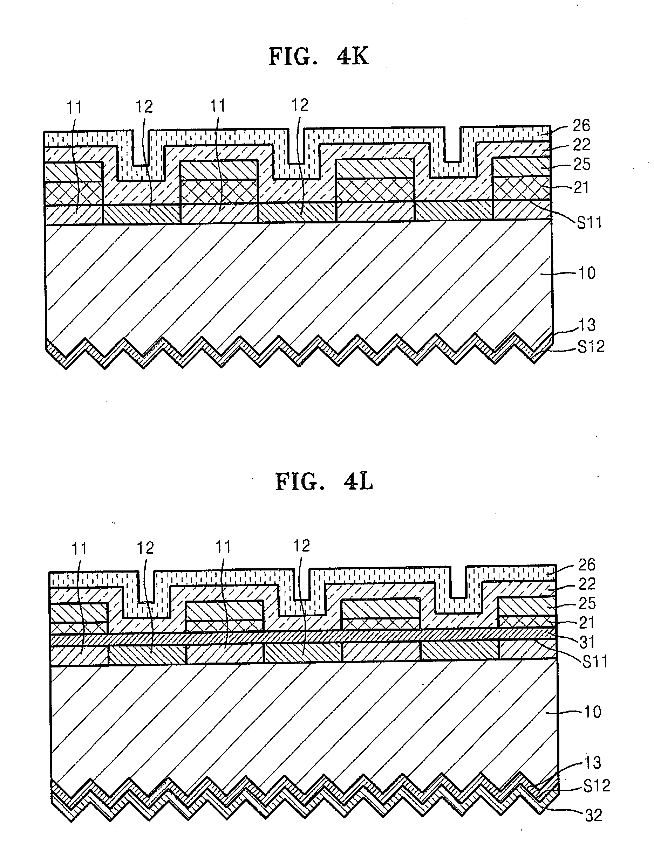

Referring to FIG. 4K, the third doping material layer 23 formed on the second surface S12 of the semiconductor substrate 10 is removed. For example, PSG or BSG as the third doping material layer 23 includes a precipitate of metal impurity components included in the semiconductor substrate 10, and thus the third doping material layer 23 can be removed. The third doping material layer 23 can be removed through wet etching using hydro fluorine acid (HF) or a BOE.

Referring to FIG. 4L, passivation layers 31 and 32 are formed in the first and second surfaces S11 and S12 of the semiconductor substrate 10. The formation of the passivation layers 31 and 32 includes an oxidation process. The passivation layers 31 and 32 including silicon oxide layers are formed.

The series of processes shown in FIGS. 4A through 4L are to form the first and second semiconductor layers 11 and 12 on the first surface S11 of the semiconductor substrate 10, and are to form the FSF 13 on the second surface S12 of the semiconductor substrate 10, which need a relatively more number of processes compared to the present invention described with reference to FIGS. 1A through 1 G.

In the manufacturing process of the present invention, the first semiconductor layer 110 is formed by applying the first ion implantation over the front surface of the semiconductor substrate 100, and applying the first and second implantations in a selected region overlappingly, and thus the counter doped second semiconductor layer 120 is formed. Accordingly, the manufacturing process of the present invention reduces manufacturing steps, which reduces a rate of occurrence of a process defect, thereby improving product yield, and reducing manufacturing cost.

Furthermore, the first and second semiconductor layers 110 and 120 of the first surface S1 of the semiconductor substrate 100 and the FSF 130 of the second surface S2 are formed through ion implantations, therefore the ion dose implanted into the semiconductor substrate 100 can be easily controlled. Additionally, by controlling the amount of energy that accelerates the ion beam during ion implantations, the doping profile and junction depth are also easily controlled. As described above, the ion dose and the doping profile are elaborately controlled, thereby reducing a junction leakage current, enhancing an open circuit voltage, and ultimately enhancing photoelectric conversion efficiency.

In the comparison example of FIGS. 4A through 4L, the first and second semiconductor layers 11 and 12 and the FSF 13 are formed through heat diffusion of PSG or BSG or through an application of the doping source like POCl₃. However, according to the comparison example, the doping concentration in the semiconductor substrate 10 is not uniform, and a distribution of photoelectric conversion efficiency for each photoelectric device takes place. In the present invention that forms the first and second semiconductor layers 110 and 120 and the FSF 130 through ion implantations, the doping concentration is uniformly improved, the distribution of photoelectric conversion efficiency for each photoelectric device is reduced, and uniform output characteristics are exhibited.

Referring to FIG. 4K of the comparison example, after the FSF 13 is formed, although wet etching is necessary for removing the third doping material layer 23 such as the additionally generated PSG or BSG, such separate wet etching is unnecessary for the present invention that applies the ion implantations. Also, a plurality of non-activation dopants exist in the FSF 13 of the comparison example, and thus absorption efficiency of single wavelength light is reduced, and surface recombination loss of carriers generated from the semiconductor substrate 10 increases.

In contrast, non-activation dopants are reduced in the FSF 130 formed through the ion implantations of the present invention, and thus the absorption efficiency of single wavelength light increases, and surface recombination loss of carriers generated from the semiconductor substrate 10 is reduced. Furthermore, an amount of energy that accelerates ion beam increases during the ion implantations, and thus an implantation depth of a dopant is increased, thereby improving a short-circuit current and an open circuit voltage and increasing the photoelectric conversion efficiency.

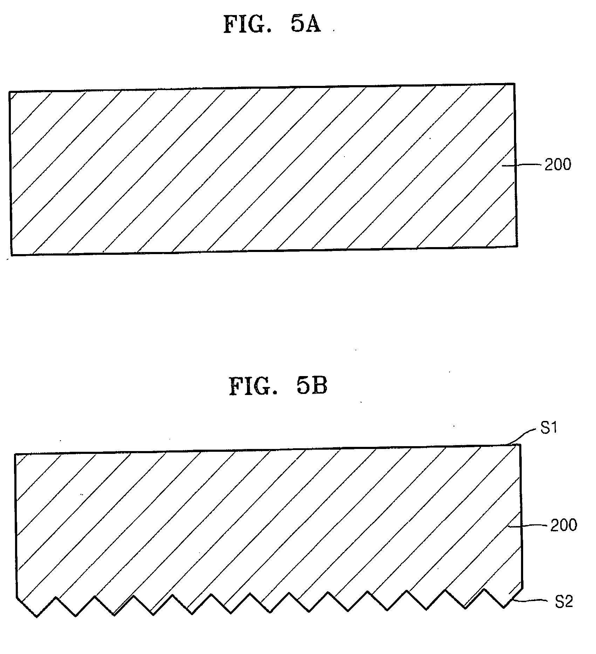

FIGS. 5A through 5L are sequential cross-sectional views for describing a method of manufacturing a photoelectric device, according to another embodiment of the present invention.

Referring to FIG. 5A, a semiconductor substrate 200 is prepared. The semiconductor substrate 200 is prepared as an n type or p type crystalline silicon wafer.

Referring to FIG. 5B, texturing is performed on the second surface S2 of the semiconductor substrate 200. For example, an etchant including IPA and adhesive added to an aqueous solution such as KOH, NaOH is applied to the semiconductor substrate 200 during texturing. In this regard, a texture structure of a pyramid pattern is formed in the second surface S2 of the semiconductor substrate 200 according to anisotropic etching characteristics with respect to a crystalline direction of single crystal silicon.

Although not shown in FIG. 5B, the texture structure of the pyramid pattern is formed in the first surface S1 of the semiconductor substrate 200, and the texture structured formed by applying the aqueous solution such as KOH, NaOH is removed. According to another embodiment of the present invention, subsequent processes are performed in a status where the texture structures are formed in the first and second surfaces S1 and S2 of the semiconductor substrate 200.

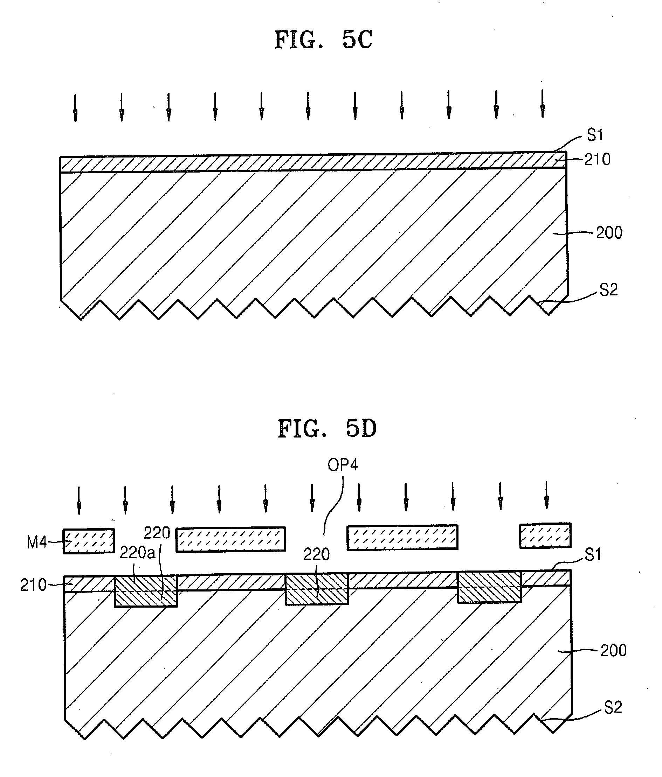

Referring to FIG. 5C, a first semiconductor layer 210 is formed on the semiconductor substrate 200 by using a first implantation. The first implantation is performed over the first surface S1 of the semiconductor substrate 200. The first semiconductor layer 210 is formed in the overall region of the semiconductor substrate 200.

The first semiconductor layer 210 is doped in a conductive type inverse to that of the semiconductor substrate 200, and forms a p-n junction. The first semiconductor layer 210 is formed as a doping layer having an inverted conductive type by implanting a p type dopant into an n type semiconductor substrate or an n type dopant into a p type semiconductor substrate. The first semiconductor layer 210 forms an emitter that collects minority carriers generated from the semiconductor substrate 200.

Referring to FIG. 5D, second semiconductor layers 220 are formed on the semiconductor substrate 200 by using a second ion implantation. The second ion implantation is performed by selectively implanting ions in a region corresponding to an opening pattern OP4 using a mask M4 in which the opening pattern OP4 is formed. The second semiconductor layers 220 are formed in a part of the semiconductor substrate 200. During the second ion implantation, counter doping that implants a dopant having an inverse conductive type to that of the first semiconductor layer 210 is performed, and thus the second semiconductor layers 220 having inverted conductive types are formed. The surfaces of the second semiconductor layers 220 include counter doping units 220a doped in the same conductive types as that of the first semiconductor layer 210 after the first ion implantation and then inverted in conductive types by implanting a dopant having an inverse conductive type during the second ion implantation.

For example, the second semiconductor layers 220 are doped with the same conductive type as that of the semiconductor substrate 200 at a higher concentration than that of the semiconductor substrate 200, and form an h-I junction (high-low junction). The second semiconductor layers 220 are formed by implanting the n type dopant into the n type semiconductor substrate 200 or implanting the p type dopant into the p type semiconductor substrate 200. The second semiconductor layers 220 form bases that collect a plurality of carriers generated from the semiconductor substrate 200. The second semiconductor layers 220 form a BSF to reduce a surface recombination loss in the first surface S1 of the semiconductor substrate 100, that is, in a rear surface thereof.

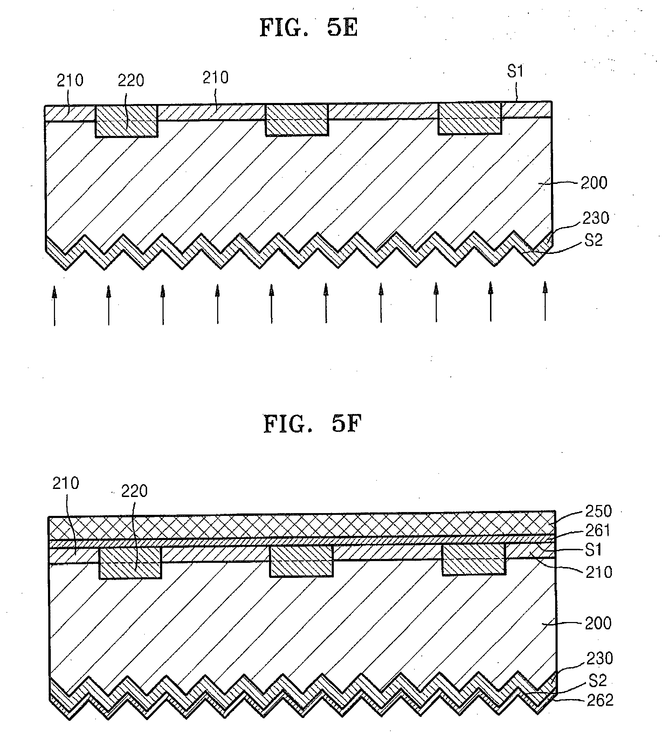

Referring to FIG. 5E, a third ion implantation is used to form a FSF 230 on the second surface S2 of the semiconductor substrate 200. The third ion implantation is over the overall second surface S2 of the semiconductor substrate 200. The FSF 230 is formed in an overall region of the second surface S2.

The FSF 230 is doped in the same conductive type as that of the semiconductor substrate 200 at a higher concentration than that of the semiconductor substrate 200 to form the h-I junction (high-low junction). The FSF 230 is formed by implanting the n type dopant into the n type semiconductor substrate 200 or implanting the p type dopant into the p type semiconductor substrate 200. For example, the FSF 230 can prevent minority carriers from moving to the second surface S2 and recombining, and reduce surface recombination loss in the second surface S2, by forming a high concentration doping layer in the second surface S2 of the semiconductor substrate 200.

Referring to FIG. 5F, an anti-diffusion layer 250 is formed on the first surface S1 of the semiconductor substrate 200. The anti-diffusion layer 250 prevents a dopant implanted into the semiconductor substrate 200 from diffusing to the outside during a thermal processing operation that will be described later. To prevent the dopant having an increased diffusion speed in a high temperature environment for thermal processing from diffusing to the outside of the semiconductor substrate 200, the anti-diffusion layer 250 is formed on the first surface S1 of the semiconductor substrate 200 in which the first and second semiconductor layers 110 and 120 are formed.

Silicate glass can be applied as the anti-diffusion layer 250. More specifically, USG that does not include the p type or n type dopant is applied as the anti-diffusion layer 250.

Referring to FIG. 5F, united thermal processing for forming passivation layers 261 and 262 on the semiconductor substrate 200 is performed, while lattice damage of the semiconductor substrate 200 due to ion shocks of the first and second ion implantations is repaired and implanted dopants are activated.

In the present embodiment, thermal processing for restoring the lattice damage of the semiconductor substrate 200 and activating the implanted dopants and passivation of the semiconductor substrate 200 are united into one process, thereby reducing waste spent in separately administrating and managing equipment for thermal processing and passivation, and thermal processing and passivation requiring a relatively long period of processing time are united into one process, thereby reducing the whole processing time and processing steps.

The united process of thermal processing forms a silicon oxide layer as the passivation layers 261 and 262 on the first and second surfaces S1 and S2, and includes an oxidation process for forming the silicon oxide layer.

For example, the united process of thermal processing includes continuously performed first and second processing. Although the first and second processing are a distinctive processes that add different processing conditions to at least one of a temperature condition, a pressure condition, and a reaction gas (or atmosphere) as processing parameters, the first and second processing conditions are part of a continuous process that is applied to the same reactor (not shown) containing the semiconductor substrate 200. For example, one of the first and second processing conditions has a main objective of the oxidation process for passivating the semiconductor substrate 200, and another has a main objective of the restoration of the lattice damage of the semiconductor substrate 200 and activation of implanted dopants.

The following i) and iv) processing conditions are added to the united process of thermal processing, and one of them is selectively applied thereto.
i) The first processing conditions include a temperature of about 950°C ∼ about 1100°C, and a pressure below 0.5 torr in a nitrogen atmosphere for 10 minutes - 100 minutes.
   In the second processing conditions, oxygen radicals are formed by supplying hydrogen and oxygen together at the same temperature of about 950°C ∼ about 1100°C as in the first processing conditions or at a lower temperature of about 800°C ∼ about 950°C than stated above and using a pressure below 0.5 torr.
ii) The first processing conditions include a temperature of about 950°C ∼ about 1100°C, and a pressure above 700 torr in a nitrogen atmosphere for 10 minutes - 100 minutes.
   The subsequent second processing conditions include an oxygen atmosphere, or a reaction gas containing hydrogen chloride or hydrogen is implanted in the oxygen atmosphere, at the same temperature of about 950°C ∼ about 1100°C as in the first processing conditions or at a lower temperature of about 800°C ∼ about 950°C than stated above and using a pressure above 700 torr.
iii) In the first processing conditions, oxygen radicals are formed by supplying hydrogen and oxygen together at a temperature of about 800°C ∼ about 950°C, and at a pressure below 0.5 torr.
   The subsequent second processing conditions include a temperature of about 950°C ∼ about 1100°C in a nitrogen atmosphere for 10 minutes - 100 minutes and at a pressure below 0.5 torr.
iv) The first processing conditions include an oxygen atmosphere, or a reaction gas containing hydrogen chloride or hydrogen implanted in the oxygen atmosphere, a temperature of about 800°C ∼ about 950°C, and a pressure above 700 torr.

The subsequent second processing conditions include a temperature of about 950°C ∼ about 1100°C in a nitrogen atmosphere for 10 minutes - 100 minutes, where the pressure is above 700 torr.

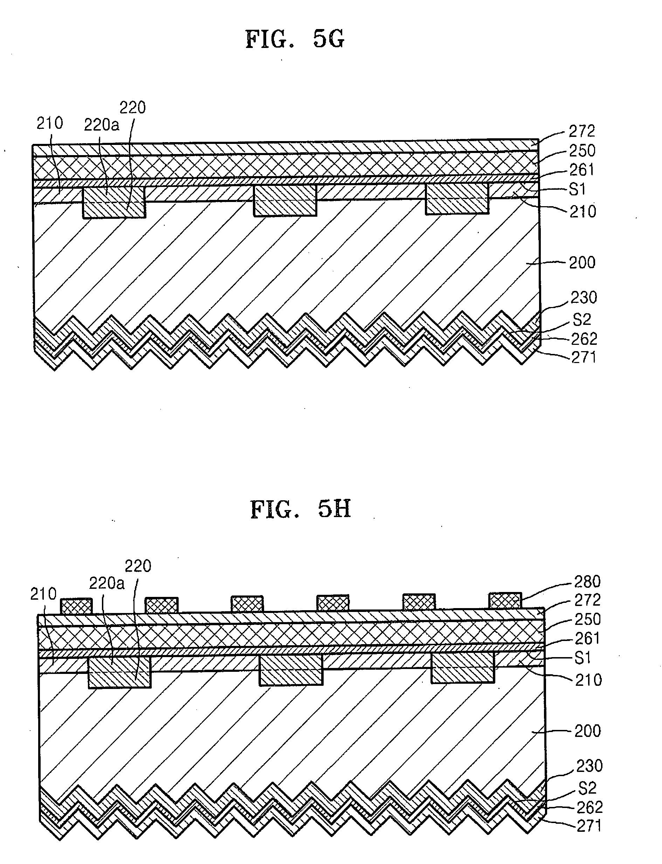

Referring to FIG. 5G, an antireflective layer 271 is formed on the second surface S2 of the semiconductor surface 200. For example, the antireflective layer 271 is formed as a silicon nitride layer (SiNx). The antireflective layer 271 can be formed by using a CVD process. The antireflective layer 271 inhibits incident light from being reflected to promote absorption of light of the semiconductor substrate 200 and increase collection efficiency of light.

Meanwhile, the antireflective layer 271 is formed on the second surface S2 of the semiconductor substrate 200 and simultaneously an additional passivation layer 272 is formed on the first surface S1. The additional passivation layer 272 reduces surface recombination loss of carriers in the first surface S1 of the semiconductor substrate 200 and enhances collection efficiency of carriers. The antireflective layer 271 of the second surface S2 an the additional passivation layer 272 of the first surface S1 can be simultaneously formed through one process, and can substantially include the same material.

Referring to FIG. 5H, an insulation layer 280 is formed on the first surface S1 of the semiconductor substrate 200. As will be described later, first and second electrodes that form an electrical connection to the first and second semiconductor layers 210 and 220 are formed, and the insulation layer 180 functions to insulate the first and second electrodes having opposite conductive types. For example, the insulation layer 280 is formed of a hardening resin material such as polyimide and is obtained by performing thermal hardening on a patterned hardening resin material by using screen printing or inkjet printing.

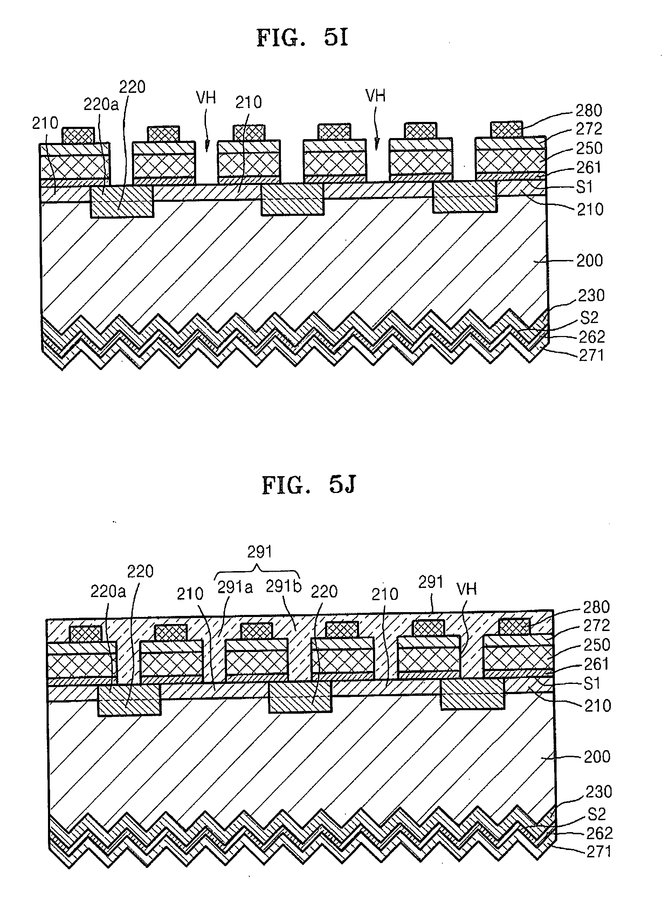

Referring to FIG. 5I, via holes VH are formed on the first surface S1 of the semiconductor substrate 200 for an electrode connection. More specifically, the via holes VH are formed by removing parts of the additional passivation layer 272, the anti-diffusion layer 250, and the passivation layer 261 that cover the first and second semiconductor layers 210 and 220 for the electrode connection. For example, the via holes VH are formed corresponding to the first and second semiconductor layers 210 and 220 that are alternately formed on the semiconductor substrate 200.

Referring to FIG. 5J, contact layers 291 are formed in the via holes VH. The contact layers 291 can include a multilayer structure in which aluminium (Al) - titanium tungsten alloy (TiW) - copper (Cu) are sequentially stacked. For example, aluminium (Al) of the contact layers 291 can be used to reduce contact resistance with the first and second semiconductor layers 210 and 220, the titanium tungsten alloy (TiW) thereof can be used to prevent copper (Cu) from diffusing, and copper (Cu) thereof can be used as a seed of a plating process that will be described later.

For example, the contact layers 291 are formed to bury the via holes VH, and are formed over the whole first surface S1 to cover the insulation layer 280 on the semiconductor substrate 100 after burying the via holes VH. In this regard, the contact layers 291 include first contact layers 291 a on the first semiconductor layer 210 and second contact layers 291 b on the second semiconductor layer 220. Although the first contact layers 291 a and the second contact layers 291 b are connected to each other, the first contact layers 291 a and the second contact layers 291 b are separated from each other through a process that will be described later, and thus are insulated from each other.

Thereafter, the forming gas annealing is performed. Thermal processing is performed in a nitrogen atmosphere containing hydrogen of about 1% ∼ about 10% and at a high temperature of about 250°C ∼ about 400°C during the forming gas annealing. The forming gas annealing can improve contact resistance between the first and second semiconductor layers 210 and 220 and the contact layers 291, and reduce a surface defect of the semiconductor substrate 200. For example, hydrogen atoms are coupled to a dangling bond and thus a defect density can be reduced.

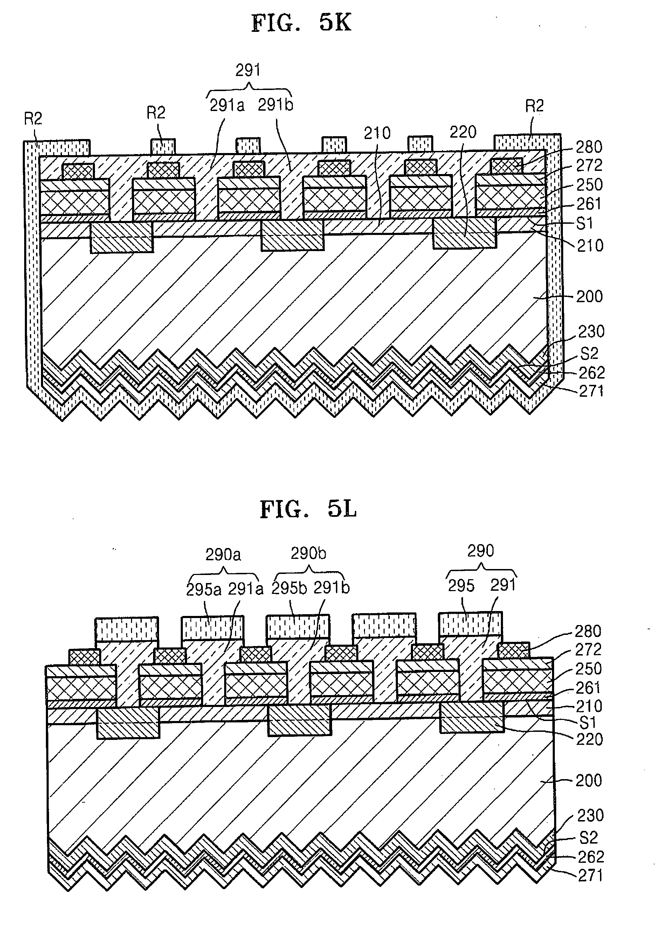

Referring to FIGS. 5K and 5L, a conductive connection layer 295 is formed on a selected part of the semiconductor substrate 200. More specifically, as shown in FIG. 5K, a resist R2 is coated. For example, the resist R2 is formed on the insulation layer 280, and is additionally formed at the outermost including side surfaces of the semiconductor substrate 200.

As shown in FIG. 5L, the conductive connection layer 295 is formed on a contact layer 291, which forms an electrode 290. For example, the conductive connection layer 295 mediates an electrical connection between the semiconductor substrate 200 and a wire substrate (not shown), and forms the electrical connection with the wire substrate through soldering. The conductive connection layer 295 can be formed by using wet electric plating having copper and tin as plating materials.

After the conductive connection layer 295 is formed, the resist R2 is removed, and thus the conductive connection layer 295 formed on the resist R2 is also removed. For example, the resist R2 can be removed by wet etching that applies chemical medicine. The contact layer 291 exposed from the conductive connection layer 295 is removed, and thus first and second electrodes 290a and 290b are separated from each other. For example, the contact layer 291 formed on the insulation layer 280 is removed, and thus the first and second electrodes 290a and 290b, more specifically, first and second contact layers 291 a and 292b, are separated from each other. Such a separation of electrodes can be performed by wet etching that applies chemicals.

For example, the first contact layer 291 a and a first conductive connection layer 295a forms the first electrode 290a electrically connected to the first semiconductor layer 210, and the second contact layer 291 b and a second conductive connection layer 295b forms the second electrode 290b electrically connected to the second semiconductor layer 220. The first and second electrodes 290a and 290b are separated from each other, and thus the first and second electrodes 290a and 290b having opposite conductive types are electrically insulated from each other.

It should be understood that the embodiments described therein should be considered in a descriptive sense only and not for purposes of limitation. Descriptions of features or aspects within each embodiment should typically be considered as available for other similar features or aspects in other embodiments.

### [Explanation of Reference Numerals]

- 100, 200:: SEMICONDUCTOR SUBSTRATE
- 110, 210:: FIRST SEMICONDUCTOR LAYER
- 120, 220:: SECOND SEMICONDUCTOR LAYER
- 120A, 220A:: COUNTER DOPING UNIT
- 130, 230:: FSF
- 150, 250:: ANTI-DIFFUSION LAYER
- 161, 162, 261, 262:: PASSIVATION LAYER
- 171, 271:: ANTIREFLECTIVE LAYER
- 172, 272:: ADDITIONAL PASSIVATION LAYER
- 180, 280:: INSULATION LAYER
- 190, 290:: ELECTRODE
- 190A, 290A:: FIRST ELECTRODE
- 190B, 290B,: SECOND ELECRODE
- 191, 291:: CONTACT LAYER
- 191A, 291A:: FIRST CONTACT LAYER
- 191B, 291B:: SECOND CONTACT LAYER
- 195, 295:: CONDUCTIVE CONNECTION LAYER
- 195A, 295A:: FIRST CONDUCTIVE CONNECTION LAYER
- 195B, 295B:: SECOND CONDUCTIVE CONNECTION LAYER
- M1, M2, M3, M4:: MASK
- SI:: FIRST SURFACE OF SEMICONDUCTOR SUBSTRATE
- S2:: SECOND SURFACE OF SEMICONDUCTOR SUBSTRATE
- OP, OP1, OP2, OP3, OP4:: OPENING PATTERN OF MASK
- C1, C2:: CLOSED PART OF MASK
- VH: VIA: HOLE
- R, R2:: RESIST

## Claims

1. A method of manufacturing a photoelectric device, the method comprising:
forming a first semiconductor layer (110, 210) on a semiconductor substrate (100, 200) through a first ion implantation;
forming a second semiconductor layer (120, 220) having a conductive type inverse to that of the first semiconductor layer in a part of the first semiconductor layer through a second ion implantation; and
performing thermal processing to repair lattice damage in the semiconductor substrate and activate dopants implanted by the first and second ion implantations,
**characterized in that**,
the first semiconductor layer is in contact with the second semiconductor layer; and
the projection range of the dopants projected into a surface of the semiconductor substrate during the second ion implantation is deeper than that of the first ion implantation.

2. The method of claim 1, wherein a dopant having a conductive type inverse to that of the semiconductor substrate is implanted during the first ion implantation, and
a dopant having the same conductive type as that of the semiconductor substrate is implanted during the second ion implantation,
optionally wherein the dopant is selectively implanted in a partial region of the semiconductor substrate corresponding to an opening pattern (OP, OP1, OP2, OP3, OP4) of a mask (M1, M2, M3, M4) during the second ion implantation.

3. The method of any one of claims 1 to 2, wherein an ion dose of the second ion implantation is higher than that of the first ion implantation.

4. The method of any one of claims 1 to 3, wherein the thermal processing is performed at a temperature of about 950°C ∼ about 1100°C, optionally in a nitrogen or oxygen atmosphere.

5. The method of any one of claims 1 to 4, wherein the depth of the second semiconductor layer is deeper than that of the first semiconductor layer; and/or
wherein the surface concentration of the second semiconductor layer dopant is higher than that of the first semiconductor layer dopant.

6. The method of any one of claims 1 to 5, further comprising: forming an anti-diffusion layer (150, 250) on the first and second semiconductor layers.

7. The method of any one of claims 1 to 6, wherein the first and second ion implantations are performed on a first surface (S1) of the semiconductor substrate and
wherein the method further comprises forming a front surface field (FSF) (130, 230) on a second surface (S2) of the semiconductor substrate through a third ion implantation.

8. The method of claim 7, further comprising, after the third ion
implantation, passivating the first and second surfaces of the semiconductor
substrate, optionally wherein the passivating comprises an oxidation process for forming a silicon oxide layer (161, 162, 261, 262) in the first and second surfaces of the semiconductor substrate.

9. The method of claims 7 or 8 wherein the method comprises:
performing a united thermal processing step, which includes thermal processing, to activate dopants implanted by the first to third ion implantations, and passivating on the first and second surfaces of the semiconductor substrate.

10. The method of claim 9, wherein the performing of the united thermal processing step comprises: forming a silicon oxide layer (161, 162, 261, 262) in the first and second surfaces of the semiconductor substrate.

11. The method of claim 9, wherein the performing of the united thermal processing comprises applying first and second processing conditions to the semiconductor substrate in a reactor,
wherein these conditions comprise:
i) first processing conditions which include a temperature of about 950°C ∼ about 1100°C, and a pressure below 0.5 torr in a nitrogen atmosphere for 10 minutes ∼ 100 minutes, and
second processing conditions, wherein oxygen radicals are formed by supplying hydrogen and oxygen together at a pressure below 0.5 torr and at a temperature of about 950°C ∼ about 1100°C as in the first processing conditions or at a temperature of about 800°C ∼ about 950°C ; or
ii) first processing conditions which include a temperature of about 950°C ∼ about 1100°C, and a pressure above 700 torr in a nitrogen atmosphere for 10 minutes ∼ 100 minutes, and
second processing conditions which include a temperature of about 950°C ∼ about 1100°C or a temperature of about 800°C ∼ about 950°C in an oxygen atmosphere and a pressure above 700 torr; or
iii) first processing conditions, wherein oxygen radicals are formed by supplying hydrogen and oxygen together at a temperature of about 800°C ∼ about 950°C, and a pressure below 0.5 torr, and
second processing conditions including a temperature of about 950°C ∼ about 1100°C and a pressure below 0.5 torr in a nitrogen atmosphere for 10 minutes - 100 minutes; or
iv) first processing conditions which include an oxygen atmosphere a temperature of about 800°C ∼ about 950°C, and a pressure above 700 torr, and
second processing conditions including a high temperature of about 950°C ∼ about 1100°C and a pressure above 700 torr in a nitrogen atmosphere for 10 minutes - 100 minutes.

12. The method of claim 11, wherein when the united thermal processing step is conducted according to the conditions of (ii) and (iv), the second processing conditions further includes a reaction gas containing hydrogen chloride or hydrogen in addition to the oxygen atmosphere.

13. The method of any one of claims 10 to 12, further comprising: forming an anti-diffusion layer (150, 250) on the first surface of the semiconductor substrate.

## Patentansprüche

1. Verfahren zum Herstellen eines fotoelektrischen Bauelements, wobei das Verfahren umfasst:
Ausbilden einer ersten Halbleiterschicht (110, 210) auf einem Halbleitersubstrat (100, 200) durch eine erste Ionenimplantation;
Ausbilden einer zweiten Halbleiterschicht (120, 220), die einen Leitungstyp hat, der umgekehrt zu jenem der ersten Halbleiterschicht ist, in einem Teil der ersten Halbleiterschicht durch eine zweite Ionenimplantation; und
Durchführen einer Wärmebehandlung, um Gitterschäden im Halbleitersubstrat zu reparieren und Dotanden zu aktivieren, die durch die ersten und zweiten Ionenimplantationen implantiert wurden,
**dadurch gekennzeichnet, dass**:
die erste Halbleiterschicht mit der zweiten Halbleiterschicht in Kontakt ist; und
die Projektionsreichweite der während der zweiten Ionenimplantation in eine Oberfläche des Halbleitersubstrats projizierten Dotanden tiefer als jene der ersten Ionenimplantation ist.

2. Verfahren nach Anspruch 1, worin während der ersten Ionenimplantation ein Dotand implantiert wird, der einen Leitungstyp hat, der umgekehrt zu jenem des Halbleitersubstrats ist, und
während der zweiten Ionenimplantation ein Dotand implantiert wird, der den gleichen Leitungstyp wie jener des Halbleitersubstrats hat,
worin optional während der zweiten Ionenimplantation der Dotand selektiv in einem Teilbereich des Halbleitersubstrats implantiert wird, der einem Öffnungsmuster (OP1, OP2, OP3, OP4) einer Maske (M1, M2, M3, M4) entspricht.

3. Verfahren nach einem der Ansprüche 1 bis 2, worin eine Ionendosis der zweiten Ionenimplantation höher als jene der ersten Ionenimplantation ist.

4. Verfahren nach einem der Ansprüche 1 bis 3, worin die Wärmebehandlung bei einer Temperatur von etwa 950 °C bis etwa 1100 °C durchgeführt wird, optional in einer Stickstoff- oder Sauerstoffatmosphäre.

5. Verfahren nach einem der Ansprüche 1 bis 4, worin die Tiefe der zweiten Halbleiterschicht tiefer als jene der ersten Halbleiterschicht ist; und/oder
worin die Oberflächenkonzentration des Dotanden der zweiten Halbleiterschicht höher als jene des Dotanden der ersten Halbleiterschicht ist.

6. Verfahren nach einem der Ansprüche 1 bis 5, ferner umfassend:
Ausbilden einer Antidiffusionsschicht (150, 250) auf den ersten und zweiten Halbleiterschichten.

7. Verfahren nach einem der Ansprüche 1 bis 6, worin die ersten und zweiten Ionenimplantationen auf einer ersten Oberfläche (S1) des Halbleitersubstrats durchgeführt werden, und
worin das Verfahren ferner umfasst: Ausbilden eines Vorderflächenfeldes (FSF) (130, 230) auf einer zweiten Oberfläche (S2) des Halbleitersubstrats durch eine dritte Ionenimplantation.

8. Verfahren nach Anspruch 7, ferner umfassend: nach der dritten Ionenimplantation erfolgendes Passivieren der ersten und zweiten Oberflächen des Halbleitersubstrats, worin das Passivieren optional einen Oxidationsprozess zum Ausbilden einer Siliciumoxidschicht (161, 162, 261, 262) in den ersten und zweiten Oberflächen des Halbleitersubstrats umfasst.

9. Verfahren nach Anspruch 7 oder 8, worin das Verfahren umfasst:
Durchführen eines vereinten Wärmebehandlungsschritts, der eine Wärmebehandlung, um Dotanden zu aktivieren, die durch die ersten bis dritten Ionenimplantationen implantiert wurden, und Passivieren auf den ersten und zweiten Oberflächen des Halbleitersubstrats umfasst.

10. Verfahren nach Anspruch 9, worin das Durchführen des vereinten Wärmebehandlungsschritts umfasst:
Ausbilden einer Siliciumoxidschicht (161, 162, 261, 262) in den ersten und zweiten Oberflächen des Halbleitersubstrats.

11. Verfahren nach Anspruch 9, worin das Durchführen des vereinten Wärmebehandlungsschritts umfasst: Anwenden erster und zweiter Behandlungsbedingungen auf das Halbleitersubstrat in einem Reaktor,
worin diese Bedingungen umfassen:
i) erste Behandlungsbedingungen, die eine Temperatur von etwa 950 °C bis etwa 1100 °C und einen Druck unterhalb von 0,5 Torr in einer Stickstoffatmosphäre für 10 Minuten bis 100 Minuten aufweisen, und
zweite Behandlungsbedingungen, worin Sauerstoffradikale ausgebildet werden, und zwar durch gemeinsames Zuführen von Wasserstoff und Sauerstoff bei einem Druck unterhalb von 0,5 Torr und bei einer Temperatur von etwa 950 °C bis etwa 1100 °C wie bei den ersten Behandlungsbedingungen oder bei einer Temperatur von etwa 800 °C bis etwa 950 °C; oder
ii) erste Behandlungsbedingungen, die eine Temperatur von etwa 950 °C bis etwa 1100 °C und einen Druck oberhalb von 700 Torr in einer Stickstoffatmosphäre für 10 Minuten bis 100 Minuten aufweisen, und
zweite Behandlungsbedingungen, die eine Temperatur von etwa 950 °C bis etwa 1100 °C oder eine Temperatur von etwa 800 °C bis etwa 950 °C in einer Sauerstoffatmosphäre und einen Druck oberhalb von 700 Torr aufweisen; oder
iii) erste Behandlungsbedingungen, worin Sauerstoffradikale ausgebildet werden, und zwar durch gemeinsames Zuführen von Wasserstoff und Sauerstoff bei einer Temperatur von etwa 800 °C bis etwa 950 °C und einem Druck unterhalb von 0,5 Torr, und
zweite Behandlungsbedingungen, die eine Temperatur von etwa 950 °C bis etwa 1100 °C und einen Druck unterhalb von 0,5 Torr in einer Stickstoffatmosphäre für 10 Minuten bis 100 Minuten aufweisen; oder
iv) erste Behandlungsbedingungen, die eine Sauerstoffatmosphäre bei einer Temperatur von etwa 800 °C bis etwa 950 °C und einen Druck oberhalb von 700 Torr aufweisen, und
zweite Behandlungsbedingungen, die eine hohe Temperatur von etwa 950 °C bis etwa 1100 °C und einen Druck oberhalb von 700 Torr in einer Stickstoffatmosphäre für 10 Minuten bis 100 Minuten aufweisen.

12. Verfahren nach Anspruch 11, worin, wenn der vereinte Wärmebehandlungsschritt gemäß den Bedingungen von (ii) und (iv) durchgeführt wird, die zweiten Behandlungsbedingungen ferner ein Reaktionsgas aufweisen, das Chlorwasserstoff oder Wasserstoff zusätzlich zu der Sauerstoffatmosphäre enthält.

13. Verfahren nach einem der Ansprüche 10 bis 12, ferner umfassend:
Ausbilden einer Antidiffusionsschicht (150, 250) auf der ersten Oberfläche des Halbleitersubstrats.

## Revendications

1. Procédé de fabrication d'un dispositif photoélectrique, le procédé comprenant les étapes consistant à :
former une première couche semi-conductrice (110, 210) sur un substrat semi-conducteur (100, 200) par l'intermédiaire d'une première implantation ionique ;
former une deuxième couche semi-conductrice (120, 220) présentant un type de conduction inverse de celui de la première couche semi-conductrice dans une partie de la première couche semi-conductrice par l'intermédiaire d'une deuxième implantation ionique ; et
mettre en oeuvre un traitement thermique afin de réparer des dommages de réseau dans le substrat semi-conducteur et activer des dopants implantés grâce aux première et deuxième implantations ioniques,
**caractérisé en ce que**,
la première couche semi-conductrice est en contact avec la deuxième couche semi-conductrice ; et
la plage de projection des dopants projetés dans une surface du substrat semi-conducteur pendant la deuxième implantation ionique est plus profonde que celle de la première implantation ionique.

2. Procédé selon la revendication 1, dans lequel un dopant présentant un type de conduction inverse de celui du substrat semi-conducteur est implanté pendant la première implantation ionique, et
un dopant présentant le même type de conduction que celui du substrat semi-conducteur est implanté pendant la deuxième implantation ionique,
éventuellement dans lequel le dopant est implanté de manière sélective dans une région partielle du substrat semi-conducteur correspondant à un motif d'ouverture (OP, OP1, OP2, OP3, OP4) d'un masque (M1, M2, M3, M4) pendant la deuxième implantation ionique.

3. Procédé selon la revendication 1 ou 2, dans lequel une dose ionique de la deuxième implantation ionique est supérieure à celle de la première implantation ionique.

4. Procédé selon l'une quelconque des revendications 1 à 3, dans lequel le traitement thermique est mis en oeuvre à une température comprise entre environ 950°C et environ 1 100°C, éventuellement dans une atmosphère d'azote ou d'oxygène.

5. Procédé selon l'une quelconque des revendications 1 à 4, dans lequel la profondeur de la deuxième couche semi-conductrice est supérieure à celle de la première couche semi-conductrice ; et/ou
dans lequel la concentration de surface du dopant de la deuxième couche semi-conductrice est supérieure à celle du dopant de la première couche semi-conductrice.

6. Procédé selon l'une quelconque des revendications 1 à 5, comprenant en outre une étape consistant à :
former une couche anti-diffusion (150, 250) sur les première et deuxième couches semi-conductrices.

7. Procédé selon l'une quelconque des revendications 1 à 6, dans lequel les première et deuxième implantations ioniques sont mises en oeuvre sur une première surface (S1) du substrat semi-conducteur, et
dans lequel le procédé comprend en outre une étape consistant à former un champ de surface avant (FSF) (130, 230) sur une deuxième surface (S2) du substrat semi-conducteur par l'intermédiaire d'une troisième implantation ionique.

8. Procédé selon la revendication 7, comprenant en outre, après la troisième implantation ionique, une étape consistant à passiver les première et deuxième surfaces du substrat semi-conducteur, éventuellement dans lequel l'étape de passivation comprend un procédé d'oxydation permettant de former une couche d'oxyde de silicium (161, 162, 261, 262) dans les première et deuxième surfaces du substrat semi-conducteur.

9. Procédé selon la revendication 7 ou 8, dans lequel le procédé comprend une étape consistant à :
mettre en oeuvre une étape de traitement thermique unifié, qui inclut un traitement thermique, afin d'activer des dopants implantés grâce aux première à troisième implantations ioniques, et une étape consistant à passiver les première et deuxième surfaces du substrat semi-conducteur.

10. Procédé selon la revendication 9, dans lequel l'étape de mise en oeuvre de l'étape de traitement thermique unifié comprend une étape consistant à :
former une couche d'oxyde de silicium (161, 162, 261, 262) dans les première et deuxième surfaces du substrat semi-conducteur.

11. Procédé selon la revendication 9, dans lequel l'étape de mise en oeuvre du traitement thermique unifié comprend une étape consistant à appliquer des première et deuxième conditions de traitement au substrat semi-conducteur dans un réacteur,
dans lequel lesdites conditions comprennent :
i) des premières conditions de traitement qui incluent une température comprise entre environ 950°C et environ 1 100°C, et une pression inférieure à 0,5 torr dans une atmosphère d'azote pendant une plage horaire comprise entre 10 minutes et 100 minutes, et
des deuxièmes conditions de traitement, dans lesquelles des radicaux oxygène sont formés par fourniture d'hydrogène et d'oxygène simultanément à une pression inférieure à 0,5 torr et à une température comprise entre environ 950°C et environ 1 100°C, comme dans les premières conditions de traitement, ou à une température comprise entre environ 800°C et environ 950°C ; ou
ii) des premières conditions de traitement qui incluent une température comprise entre environ 950°C et environ 1 100°C, et une pression supérieure à 700 torr dans une atmosphère d'azote pendant une durée comprise entre 10 minutes et 100 minutes, et
des deuxièmes conditions de traitement qui incluent une température comprise entre environ 950°C et environ 1 100°C ou une température comprise entre environ 800°C et environ 950°C dans une atmosphère d'oxygène et une pression supérieure à 700 torr ; ou
iii) des premières conditions de traitement, dans lequel des radicaux oxygène sont formés par fourniture d'hydrogène et d'oxygène simultanément à une température comprise entre environ 800°C et environ 950°C, et à une pression inférieure à 0,5 torr, et
des deuxièmes conditions de traitement incluant une température comprise entre environ 950°C et environ 1 100°C et une pression inférieure à 0,5 torr dans une atmosphère d'azote pendant une durée comprise entre 10 minutes et 100 minutes ; ou
iv) des premières conditions de traitement qui incluent une atmosphère d'oxygène, à une température comprise entre environ 800°C et environ 950°C, et une pression supérieure à 700 torr, et
des deuxièmes conditions de traitement incluant une température élevée comprise entre environ 950°C et environ 1 100°C et une pression supérieure à 700 torr dans une atmosphère d'azote pendant une durée comprise entre 10 minutes et 100 minutes.

12. Procédé selon la revendication 11, dans lequel l'étape de traitement thermique unifié est mise en oeuvre conformément aux conditions de (ii) et (iv), les deuxièmes conditions de traitement incluant en outre un gaz réactionnel contenant du chlorure d'hydrogène ou de l'hydrogène en plus de l'atmosphère d'oxygène.

13. Procédé selon l'une quelconque des revendications 10 à 12, comprenant en outre une étape consistant à :
former une couche anti-diffusion (150, 250) sur la première surface du substrat semi-conducteur.
